# EUROPÄISCHE PATENTSCHRIFT

(11) **EP 2 876 980 B1**
(45) Veröffentlichungstag und Bekanntmachung des Hinweises auf die Patenterteilung: **17.06.2020**
(21) Anmeldenummer: 14194615.2
(22) Anmeldetag: 25.11.2014
(51) Int. Cl.: H05K 5/00

(54) **Gehäuse mit Einlegeteil aus Kunststoff**
Plastic housing with insert
Boîtier ayant une pièce d'insertion en matière plastique

(30) Priorität: 25.11.2013 DE 202013010542 U
(43) Veröffentlichungstag der Anmeldung: 27.05.2015
(73) Patentinhaber: Lisa Dräxlmaier GmbH, 84137 Vilsbiburg (DE)
(72) Erfinder: Leitner, Manuel, 5280 Braunau (AT)

(56) Entgegenhaltungen:
- US-A- 5 641 306
- US-A- 5 879 115
- US-A1- 2009 300 893
- US-B1- 6 420 652

## Beschreibung

### Gebiet der Erfindung

Die vorliegende Erfindung betrifft ein Gehäuse mit einem Einlegeteil. Derartige Gehäuse werden beispielsweise in Kraftfahrzeugen als E-Boxen, Steuergerätehalter oder Kabelschächte verwendet, um Elektronik oder andere empfindlichen Bauteile von äußeren mechanischen oder chemischen Einflüssen zu schützen.

Die vorliegende Erfindung betrifft ferner ein Verfahren zur Herstellung eines Gehäuses, sowie ein Verfahren zur Herstellung eines Einlegeteils.

### Stand der Technik

Gehäuse mit Einlegeteilen, beispielsweise Buchsen, sind im Stand der Technik allgemein bekannt. Die Gehäuse werden unter anderem dazu verwendet, um elektronische oder elektrische Bauteile von der äußeren Umgebung zu trennen und somit vor äußeren Einflüssen, beispielsweise Wasser, Staub, Temperatur oder Zugriff durch unbefugte Personen zu schützen. Um diese Gehäuse an ihrem unmittelbaren Umfeld, beispielsweise an einem Gerüst, zu befestigen, weisen diese Öffnungen auf, über die die Gehäuse mittels Befestigungsmittel, beispielsweise Schrauben, mit dem Gerüst, beispielsweise Karosserie eines Kraftfahrzeugs, befestigt werden.

In der amerikanischen Patentschrift US 6 420 652 B1 wird eine Buchse aus Kunststoff offenbart. Die Kunststoffbuchse weist ein Durchgangsloch auf und eine mehrseitige Umfassung. Dabei umfasst der Kunststoff Glasfasern, die in Längsrichtung des Durchgangsloches ausgerichtet sind. Optimal weist die Kunststoffbuche die gleichen Wärmeausdehnungskoeffizienten auf wie das Kunststoffgehäuse, in dem diese eingesetzt, umspritzt oder umgossen ist. Eine alternative Einlegebuchse aus Kunststoff wird in der US 5 879 115 A beschrieben.

Neben dynamischen Belastungen (beispielsweise aus Vibrationen des Gerüsts resultierend) ist ein Gehäuse daher auch statischen Belastungen durch das Befestigungsmittel ausgesetzt. Die Belastungen können zu einem Kriechen des belasteten Materials führen, was zu einer langsam fortschreitenden plastischen Verformung des Materials führen kann. Aus dieser Last resultiert also ein Fließen oder Kriechen und eine damit einhergehende Verformungen des Materials. Die Verformung des Materials führt dazu, dass die Spannkraft bzw. Befestigungskraft des Befestigungsmittels reduziert wird und dieses seinen ursprünglichen Zweck, nämlich die Befestigung eines Bauteils, nicht mehr erfüllt.

Im Stand der Technik werden deshalb die Einlegeteile aus Metall, beispielsweise Aluminium oder Stahl, hergestellt, da dieses bislang aufgrund seiner Härte und Kriechfestigkeit als adäquates Material galt. Entsprechende Einlegeteile sind beispielsweise in der amerikanischen Patentanmeldung US 2009/300893 A1 beschrieben.

### Aufgabe der vorliegenden Erfindung

Die Aufgabe der vorliegenden Erfindung ist es ein Gehäuse mit einem Einlegeteil anzugeben, wobei das Einlegeteil die vorgenannten Nachteile überwindet. Insbesondere soll das erfindungsgemäße Einlegeteil leicht sein und eine dauerhaft hohe statische wie auch dynamische Belastung widerstehen, ohne dabei Ermüdungserscheinungen zu zeigen oder zerstört zu werden. Dieses Ziel wird erfindungsgemäß durch ein Gehäuse gemäß dem Anspruch 1 gelöst. Weitere bevorzugte Ausführungsformen sind in den abhängigen Ansprüchen aufgeführt.

Kerngedanke der Erfindung ist es, das Einlegeteil in dem Gehäuse, welches bisher aus Aluminium, Stahl oder einem sonstigen Metall hergestellt wurde, durch ein Einlegeteil aus einem Material zu ersetzen, das den oben genannten Ansprüchen genügt. Erfindungsgemäß weist das Material zumindest einen zweiten Kunststoff mit zumindest einem granularen und/oder faserförmigen Füllstoff auf. Das Einlegeteil ist mit dem Gehäuse kraftschlüssig und/oder formschlüssig verbunden und kann als Standardbauteil geliefert werden und anschließend mit dem Gehäuse verbunden werden. Eine kraftschlüssige Verbindung in dem Sinne der Erfindung ist beispielsweise das Einpressen des Einlegeteils in das Gehäuse. Das heißt, dass das Einlegteil mit hoher Kraft in das Gehäuse, insbesondere in eine dafür vorgesehene Öffnung des Gehäuses, eingedrückt wird. Um das Gehäuse weiterhin mit der Umgebung zu verbinden, weist das Einlegeteil eine Durchgangsöffnung auf, durch die ein Befestigungsmittel geführt werden kann. Dieses Befestigungsmittel kann beispielsweise eine Schraube oder eine Niete sein.

Indem das Einlegeteil ein Material aufweist, das zumindest einen zweiten Kunststoff mit zumindest einem granularen und/oder faserförmigen Füllstoff umfasst, kann das Einlegeteil besonders leicht sein und besonders hohe Kräfte, insbesondere große Anzugsdrehmomente, aufnehmen, ohne dabei zerstört zu werden. Darüber hinaus weist ein Einlegeteil, das aus diesem Material gebildet ist, weitere vorteilhafte Eigenschaften auf. Insbesondere ist Kunststoff nicht korrosionsanfällig, wie es ein metallisches Einlegeteil wäre. Ferner kann das erfindungsgemäße Einlegeteil verschiedene Formen aufweisen, da es durch ein Spritzgießverfahren in besonders einfacher Weise herstellbar ist.

Gemäß einer Weiterbildung des erfindungsgemäßen Gehäuses ist vorgesehen, dass das Einlegeteil als Buchse ausgebildet ist. Die Buchse kann als DIN-Teil, d.h. als Norm- oder Standartteil, gebildet sein oder auch als Bauteil geformt sein, das individuelle Vorgaben, wie beispielsweise Länge, an die Öffnung oder Befestigungsmittel angepasste Querschnittsform, hergestellt sein. Buchsen sind in der Regel als hohlzylinderförmige Bauteile bekannt und können eine oder mehrere Auflagenflächen aufweisen, die in Form eines Kragens senkrecht zur Außenumfangsfläche verlaufen.

Gemäß einer bevorzugten Weiterbildung des Gehäuses ist vorgesehen, dass der Füllstoff einen Anteil von 30 bis 90 Volumenprozent, insbesondere von 40 bis 80 Volumenprozent, insbesondere von 50 bis 70 Volumenprozent, insbesondere von 60 Volumenprozent, insbesondere von 50 Volumenprozent, des Einlegeteils aufweist.

Der Anteil des Füllstoffs innerhalb des Einlegeteils hat wesentlichen Einfluss auf die Belastbarkeit und Kriechfestigkeit des Einlegeteils. Die Belastbarkeit und Kriechfestigkeit nimmt mit steigendem Anteil an Füllstoff ebenfalls zu. Dabei liegt die obere Grenze bei etwa 90 Volumenprozent. Messungen haben ergeben, dass das Einlegeteil mit einem Füllstoffanteil von etwa 60 Volumenprozent Belastungen von 15 Nm zerstörungsfrei übersteht, ohne dabei Ermüdungserscheinungen zu zeigen. Des Weiteren kann der Füllstoff die Temperaturbeständigkeit des Einlegeteils in vorteilhafter Weise beeinflussen. Gegenüber einem Einlegeteil, das aus einem Kunststoff ohne Füllstoff gebildet ist, weist das Einlegeteil mit einem Material, das einen zweiten Kunststoff und Füllstoff umfasst, somit verbesserte Eigenschaften auf. Darüber hinaus ist ein derart ausgebildetes Einlegeteil leichter als ein Einlegeteil aus Metall. Zu dem kann das Einlegeteil aufgrund des Füllstoffes leichter sein, als das Einlegeteil ohne Füllstoff. Ein entsprechend ausgebildetes Gehäuse ist somit insgesamt leichter als die bisher aus dem Stand der Technik bekannten Gehäuse.

Gemäß einer bevorzugten Weiterbildung des erfindungsgemäßen Gehäuses ist vorgesehen, dass der zweite Kunststoff einen thermoplastischen Kunststoff und der Füllstoff ein synthetisches und/oder mineralisches Material, insbesondere Kohlenstofffasern, Glasfasern und/oder Glaskugeln, umfasst.

Durch die Verwendung eines thermoplastischen Kunststoffs kann die Schmelztemperatur des Einlegeteils weiter erhöht werden. Beispiele für Füllstoffe sind Glas-Fasern, Basalt-Fasern und Carbon-Fasern (CFK)

Ein aus Metall gebildetes Einlegeteil bildet eine elektrisch leitende Brücke zwischen dem Äußeren und dem Inneren des Gehäuses. Gemäß einem nicht zur Erfindung gehörenden Beispiel ist vorgesehen, dass das Material des Einlegeteils einen hohen elektrischen Isolationswiderstand aufweist. Somit werden Elemente im Inneren des Gehäuses nicht nur durch mechanische oder chemische Einwirkungen geschützt. Vielmehr werden die im Inneren des Gehäuses befindlichen Teile zudem noch vor elektrischen Strom geschützt. Dies ist umso vorteilhafter, als dass die innerhalb des Gehäuses befindlichen Bauteile in der Regel elektronische oder elektrische Bauteile aufweisen, welche durch einen unkontrollierten elektrischen Strom leicht beschädigt werden können.

In einer weiteren Ausgestaltung des Gehäuses weist die Durchgangsöffnung des Einlegeteils ein Gewinde auf. Damit kann ein Befestigungsmittel oder ein Verbindungselement, z. B. eine Schraube, form- und/oder kraftschlüssig in das Einlegeteil aufgenommen werden.

Gemäß einer Weiterbildung des erfindungsgemäßen Gehäuses ist vorgesehen, dass der Füllstoff eine Kurzschnittfaser, insbesondere Glas-Basalt und Kohlenstofffaser, umfasst. Kurzschnittfasern sind besonders einfach zu handhaben und sind für das Spritzgießen besonders geeignet. Sie lassen sich einfach in einen Kunststoff einbringen und weisen eine geringere Dichte als Stahl auf.

Gemäß einem nicht zur Erfindung gehörenden Beispiel des Gehäuses ist vorgesehen, dass der zweite Kunststoff ein Polyamid, insbesondere Polyamid-6.6, Polyamid-6 und/oder Polyamid-4.6, umfasst. Polyamid weist hohe mechanische Festigkeit, Härte, Steifigkeit und Zähigkeit auf. Darüber hinaus weist es ein hohes mechanisches Dämpfungsvermögen und eine hohe Ermüdungsfestigkeit auf. Des Weiteren ist Polyamid resistent gegen Feuchteaufnahme und weist meist eine geringe Dimensionsstabilität auf. Es kann sowohl im Gussverfahren wie auch im Extrusionsverfahren verwendet werden.

Gemäß einer weiteren Ausgestaltung des Gehäuses ist vorgesehen, dass der zweite Kunststoff Polyetheretherketon (PEEK) umfasst. Polyetheretherketon ist ein hochtemperaturbeständiger thermoplastischer Kunststoff und weist eine Schmelztemperatur von etwa 335°C auf.

Gemäß einer Weiterbildung des Gehäuses ist vorgesehen, dass das Einlegeteil rotationssymmetrisch um die Längsachse der Durchgangsöffnung ausgebildet ist. Dadurch kann das Einlegeteil in einfacher Weise hergestellt werden und kann ebenfalls einfach montiert bzw. eingelegt werde, da beim Einlegen die Rotationssymmetrie eine bestimmte Ausrichtung um die Rotationsachse des Einlegeteils überflüssig macht.

Gemäß einer bevorzugten Weiterbildung des Gehäuses ist vorgesehen, dass das Einlegeteil eine Auflagefläche aufweist, insbesondere zur Auflage von Verbindungsmitteln, wobei die Auflagefläche sich in einem Winkel von 90° zur Längsachse der Durchgangsöffnung erstreckt. Durch die Ausbildung einer Auflagefläche kann die Druckbelastung, die durch ein Verbindungsmittel, beispielsweise eine Schraube, auf das Gehäuse wirken kann, ausschließlich auf das Einlegeteil umgelenkt werden. Dabei wirkt die Schraube auf die Auflagefläche des Einlegeteils, so dass das Einlegeteil die Kraft bzw. das Anzugsmoment auf das Gerüst überträgt, auf dem sich das Gehäuse befindet.

Ferner können mehrere Auflageflächen an einem Einlegeteil vorgesehen sein. Dabei bildet die erste Auflagefläche eine Fläche, auf der sich das Verbindungsmittel befindet. Eine zweite Auflagefläche kann an dem Ende des Einlegeteils vorgesehen sein, mit der das Einlegeteil auf dem Gerüst aufliegt.

Die Auflagefläche erstreckt sich vorzugsweise in einem Winkel von etwa 90° zur Längsachse der Durchgangsöffnung. Sie kann sich aber auch in einem anderen Winkel zur Längsachse der Durchgangsöffnung erstrecken, beispielsweise dann, wenn das Einlegeteil auf einem Gerüst aufliegt, das relativ schräg zum Gehäuseteil verläuft. In diesem Fall schließt bereits die Längsachse der Durchgangsöffnung einen Winkel ein, der kleiner bzw. größer als 90° ist. Die Ausgestaltung der Auflagefläche kann beliebig sein. Die Auflagefläche ist jedoch bevorzugt plan und bildet einen Kragen, der sich um das Einlegeteil herum erstreckt.

Gemäß einer bevorzugten Weiterbildung des Gehäuses ist vorgesehen, dass das Einlegeteil eine Farbe aufweist, die einer Materialeigenschaft und/oder einer geometrischen Eigenschaft des Einlegeteils zuordenbar ist. Eine Materialeigenschaft kann insbesondere die Zug-/Druckfestigkeit oder Torsionsfestigkeit des Einlegeteils sein. Eine geometrische Eigenschaft kann beispielsweise die Länge, der Außendurchmesser des Einlegeteils sein und/oder der Durchmesser der Durchgangsöffnung. Durch das Vorsehen einer Farbe des Einlegeteils wird also die Montage weiter erleichtert, da über die Farben eine besondere Eigenschaft des Einlegeteils codiert wird. Beispielsweise kann ein rotes Einlegeteil eine besonders druckfeste Eigenschaft des Einlegeteils signalisieren, wobei gleichzeitig der Außendurchmesser einen relativ großer Außendurchmesser aufweisen kann. Weiterhin könnte eine andere Farbe des Einlegeteils, beispielsweise blau, dazu genutzt werden, um die Durchgangsöffnung nicht als kreisrunde Durchgangsöffnung auszugestalten, sondern als beispielsweise sechseckförmige Durchgangsöffnung. So kann eine Person, die sich mit der Montage des Einlegeteils beschäftigt, in einfacher Weise die Eigenschaften des Einlegeteils erkennen und schnell nach dem Einlegeteil mit der Frage greifen, das die richtigen Eigenschaften aufweist. Dadurch werden der Montageaufwand und die Kontrolle, welche sich an die Montage anschließt, erleichtert.

Gemäß einer Weiterbildung des erfindungsgemäßen Gehäuses ist vorgesehen, dass das Einlegeteil einen hohlzylinderförmigen Bereich aufweist, der an seiner Außenumfangsfläche aufgeraut und/oder zahnradförmig profiliert ist. Die starke Aufrauung oder Profilierung, insbesondere zahnradförmige Profilierung, ist für die formschlüssige Verbindung zwischen Einlegeteil und Gehäuse vorteilhaft. Durch das Aufrauen wird die Oberfläche des Einlegeteils geöffnet, so dass beim Spritzgießverfahren eine formschlüssige Verbindung erleichtert wird. Durch die zahnradprofilierte Außenumfangsfläche wird darüber hinaus noch eine formschlüssige Verbindung erzeugt, so dass das Einlegeteil besonders fest mit dem Gehäuse verbunden ist.

Gemäß einer Weiterbildung des Gehäuses ist vorgesehen, dass das Einlegeteil zur Bildung des Gehäuses mit dem ersten Kunststoff umspritzt ist. Auf diese Weise kann das Einlegeteil separat vom Gehäuse hergestellt werden, wobei nach der Herstellung des Einlegeteils dieses mit einem Kunststoff umspritzt wird, so dass das Gehäuse gebildet wird. Dadurch ist eine besonders einfache und kostengünstige Herstellung des Gehäuses mit dem Einlegeteil möglich.

Gemäß einer Weiterbildung des erfindungsgemäßen Gehäuses ist vorgesehen, dass das Einlegeteil in eine dafür vorgesehene Öffnung des Gehäuses eingepresst ist. Das Einlegeteil kann somit separat vom Gehäuse hergestellt werden, wobei anschließend beide Teile, also das Gehäuse und das Einlegeteil, zusammengeführt werden. Um eine besonders feste Verbindung zu erzeugen, werden die beiden Bauteile zusammengepresst. Auf diese Weise entsteht zumindest eine kraftschlüssige Verbindung.

Gemäß einer Weiterbildung des Gehäuses ist vorgesehen, dass das Einlegeteil in eine dafür vorgesehene Öffnung des Gehäuses eingespritzt ist. Mit anderen Worten wird zunächst das Gehäuse beispielsweise durch Spritzgießen hergestellt, wobei anschließend das Einlegeteil ebenfalls durch Spritzgießen innerhalb des Gehäuses, d.h. insbesondere in dafür vorgesehene Öffnungen, eingespritzt wird. Die vorgesehenen Öffnungen werden somit bereits im Spritzgießprozess des Gehäuses gebildet, wobei die Öffnungen in Bereichen vorgesehen sind, an denen das Gehäuse an einem Gerüst befestigt wird. Auf diese Weise kann die äußere Form des Einlegeteils eine beliebige Gestalt aufweisen, da die Außenform der Öffnung, in die das Einlegeteil eingespritzt wird, durch das Einlegeteil vollständig ausgefüllt. Dadurch entsteht eine formschlüssige und kraftschlüssige Verbindung.

Als nicht zu dieser Erfindung gehörende Beispiele sind des Weiteren folgende Verfahren offenbart:
Verfahren zur Herstellung eines Kunststoffbauteils mit mindestens einem zuvor beschriebenen Einlegeteil, wobei das Einlegeteil in ein Spritzgusswerkzeug eingelegt wird und anschließend mit dem ersten Kunststoff des herzustellenden Kunststoffteils umspritzt wird.
Verfahren zur Herstellung eines Kunststoffbauteils, wobei das Kunststoffbauteil durch Spritzgießen hergestellt wird und anschließend ein zuvor beschriebenes Einlegeteil in dafür vorgesehene Öffnungen im Kunststoffteil spritzgeformt wird.
Verfahren zur Herstellung eines zuvor beschriebenen Einlegeteils, wobei der zweite Kunststoff und das Füllmaterial vermischt werden und anschließend über eine Spritzgussmaschine in ein Werkzeug zur Spritzformung des Einlegeteils eingespritzt werden.

### Kurze Beschreibung der Zeichnungen

- Figur 1: zeigt eine schematische Ansicht eines Gehäuses mit einem eingepressten Einlegeteil.
- Figur 2: zeigt schematisch eine Ansicht eines Einlegeteils mit einer Zahnradprofilierung.
- Figur 3: zeigt ein Einlegeteil gemäß einer weiteren Ausführungsform der vorliegenden Erfindung.
- Figur 4: zeigt eine Ausführungsform eines Einlegeteils ohne Gehäuse.

### Detaillierte Beschreibung der bevorzugten Ausführungsformen

Die vorliegende Erfindung wird rein beispielhaft anhand der nachfolgenden Ausführungsformen der Einlegeteile beschrieben.

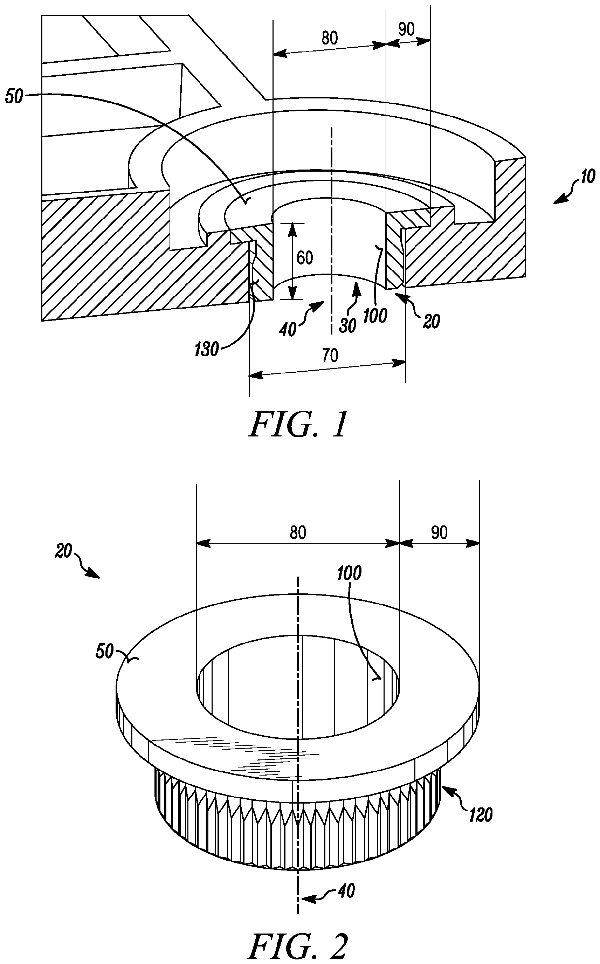

Figur 1 zeigt ausschnittsweise ein Gehäuse 10 mit einem darin eingepressten Einlegeteil 20. Das Einlegeteil 20 ist in eine Öffnung 130 des Gehäuses 10 eingepresst. In dieser Ausführungsform weist das Einlegeteil 20 Auflageflächen 50 auf, die in einem Winkel von 90 Grad zu der Längsachse einer Durchgangsöffnung 30 verläuft. Die Auflagefläche 50 weist eine Breite 90 auf, die über den hohlzylindrischen Bereich des Einlegeteils 20 hinausragt. Die Auflagefläche 50 schließt dabei bündig mit dem Gehäuseteil 10 ab. Ein nicht dargestelltes Verbindungsmittel würde auf die Auflagefläche 50 wirken, wobei die aufgebrachte Verbindungskraft auf die Auflagefläche und über den hohlzylindrischen Bereich 100 des Einlegeteils 20 auf ein nicht dargestelltes Gerüst wirken würde. Das Einlegeteil 20 aus Figur 1 ist buchsenförmig ausgebildet und weist eine Länge 60 auf und einen Außendurchmesser 70. Beim Ausführungsbeispiel gemäß Figur 1 weist das Material des Einlegeteils 20 eine höhere Festigkeit auf als der Kunststoff des Gehäuses 10. Das Verbindungsmittel würde zwar weiterhin das Gehäuse 10 berühren, weil das Gehäuse 10 bündig mit dem Einlegeteil 20 abschließt, jedoch würden die Kräfte über die Auflageflächen 50 bzw. den hohlzylinderförmigen Bereich 100 auf das umliegende Gerüst übertragen werden. Das Gehäuse 10 würde somit durch die Verwendung des Einlegeteils aus dem Belastungsbereich, der durch das Verbindungsmittel entsteht, ausgenommen werden, so dass das Material des Gehäuses 10 relativ weich ausgebildet sein kann, ohne die Funktion des Gehäuses 10 zu beeinträchtigen.

Das Einlegeteil aus Figur 1 besteht aus Polyamid-6.6, wobei dieses mit Kohlenstofffasern (nicht dargestellt) gefüllt ist. Der Anteil an Kohlenstofffasern beträgt etwa 60 Volumenprozent des Einlegeteils 20. Durch die Verwendung der Kohlenstofffasern wird die Festigkeit des Einlegeteils 20 im Vergleich zu einem Einlegeteil ohne einen Füllstoff auf 15 Nm erhöht. Gleichzeitig wurde das Gewicht gegenüber einem Einlegteil aus Metall um 50 % reduziert.

Figur 2 zeigt ein weiteres Ausführungsbeispiel eines Einlegeteils 20, wobei dieses Einlegeteil 20 eine zahnradförmige Außenzahnradprofilierung 120 aufweist. Das Einlegeteil 20 aus Figur 2 weist ebenfalls Auflagenflächen 50 auf, die senkrecht von der Längsachse 40 der Durchgangsöffnung 30 abstehen. Der hohlzylinderförmige Bereich 100 ist im Querschnitt kreisförmig ausgebildet, so dass ein Befestigungsmittel, insbesondere eine Schraube, durch die Durchgangsöffnung hindurchgeführt werden kann. Wie bereits erwähnt, weist die Außenumfangsfläche 110 des Einlegeteils 20 gemäß Figur 2 eine zahnradförmige Profilierung 120 auf, so dass das Einlegeteil 20 gemäß Figur 2 sowohl dazu geeignet ist, eingepresst zu werden, als auch dazu geeignet ist, in einem Spritzgussverfahren eingesetzt zu werden. In diesem Fall würde das Einlegeteil in ein Werkzeug eingelegt und anschließend um das Einlegeteil herum ein erster Kunststoff eingespritzt werden, so dass ein Gehäuse gebildet wird. Die zahnradförmige Profilierung 120 erzeugt dabei eine form- und/oder kraftschlüssige Verbindung zwischen Einlegeteil 20 und Gehäuse. Das Einlegeteil besteht aus Polyamid-6.6, wobei dieses mit Glaskugeln (nicht dargestellt) gefüllt ist. Der Anteil an Glaskugeln beträgt etwa 80 Volumenprozent des Einlegeteils 20, wodurch sich die Festigkeit des Einlegeteils 20 im Vergleich zu einem Einlegeteil ohne Füllstoff auf ebenfalls erhöht. Gleichzeitig wurde das Gewicht gegenüber einem Einlegteil aus Metall um etwa 40 % reduziert.

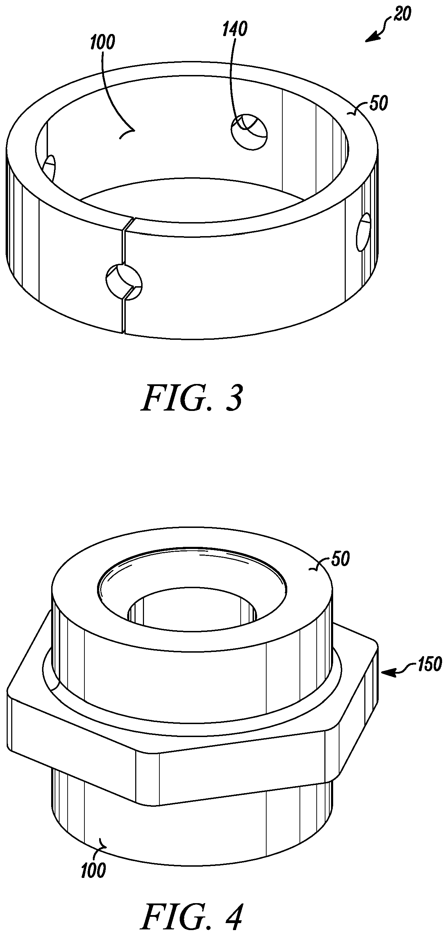

Das Einlegeteil 20 gemäß Figur 3 ist im Wesentlichen zylinderförmig ausgebildet. Auf den Zylinderwänden sind Durchbrüche 140 ausgebildet, welche einen kreisförmigen Querschnitt bilden. Die Ausführungsform gemäß Figur 3 des Einlegeteils 20 weist ebenfalls eine Auflagefläche 50 auf, wobei diese durch die Dicke des hohlzylinderförmigen Bereichs 100 gebildet ist. In diesem Fall ist die Dicke des hohlzylinderförmigen Bereichs 100 ausreichend groß, um eine Auflagefläche 50 zu bilden. Die Durchbrüche 140 bieten dem Einlegeteil 20 eine Möglichkeit, innerhalb des Gehäuses 10 mit dem Kunststoff des Gehäuses 10 formschlüssig in Verbindung zu treten. Mit anderen Worten wird das Einlegeteil 20 gemäß Figur 3 in einem Spritzgießverfahren umspritzt, wobei sich der Kunststoff des zu bildenden Gehäuses 10 um das Einlegeteil 20 herum bildet und in die Durchbrüche 140 eindringt und so formschlüssig verbunden ist. Das Einlegeteil 20 gemäß Figur 3 eignet sich daher vorzugsweise, aber nicht ausschließlich, zum Umspritzen mit einem Kunststoff. Um die Verbindung zwischen dem umspritzten Kunststoff zur Bildung des Gehäuses und dem Einlegeteil zu verstärken, sind die Innen- und Außenwand des zylinderförmigen Einlegeteils 20 rau ausgebildet. Neben der formschlüssigen Verbindung durch die Durchbrüche 140 wird dadurch eine kraftschlüssige Verbindung ermöglicht und so die Verbindung zwischen Einlegeteil 20 und dem in dieser Figur nicht dargestellten Gehäuse weiter verbessert.

Figur 4 zeigt eine weitere Ausführungsform des Einlegeteils 20, wobei das Einlegeteil einen sechskantförmigen Kranz 150 aufweist. Der Kranz 150 befindet sich auf der Außenumfangsfläche des hohlzylinderförmigen Bereichs 100 des Einlegeteils 20. Das Einlegeteil 20 gemäß Figur 4 kann zum einen zum Einpressen verwendet werden. Dabei wird das Einlegeteil 20 bis zum Kranz 150 in eine dafür vorgesehene Öffnung des in der Figur 4 nicht dargestellten Gehäuses eingepresst werden. Der Kranz 150 befindet sich dann oberhalb des Gehäuses oder kann auch auf dem Gehäuse bündig aufliegen. Das Einlegeteil 20 gemäß Figur 4 kann auch durch ein Spritzgießverfahren mit einem ersten Kunststoff umspritzt werden. In diesem Fall wird der Kranz 150 vollständig vom ersten Kunststoff umgeben. Dabei ragt lediglich die Auflagefläche 50 des Hohlzylinders aus dem ersten Kunststoff heraus. Alternativ oder ergänzend kann sich die Auflagefläche 50 auch auf dem Kranz 150 befinden. Dies hängt im Wesentlichen von dem gewählten Verbindungsmittel ab.

### Bezugszeichenliste

- 10: Gehäuse
- 20: Einlegeteil
- 30: Durchgangsöffnung
- 40: Längsachse der Durchgangsöffnung
- 50: Auflagefläche
- 60: Länge des Einlegeteils
- 70: Außendurchmesser
- 80: Durchmesser der Durchgangsöffnung
- 90: Breite der Auflagefläche
- 100: Hohlzylinderförmiger Bereich
- 110: Außenumfangsfläche
- 120: Zahnradförmige Profilierung
- 130: Öffnung des Gehäuses
- 140: Durchbruch
- 150: Kranz

## Patentansprüche

1. Gehäuse (10) aus einem ersten Kunststoff mit einem kraftschlüssig und/oder formschlüssig verbundenen Einlegeteil (20) mit einer Durchgangsöffnung (30) zur Aufnahme eines Befestigungsmittels, wobei das Einlegeteil ein Material aufweist, das zumindest einen zweiten Kunststoff mit zumindest einem Anteil von 30 bis 90 Volumenprozent granularen und/oder faserförmigen Füllstoff umfasst, wobei der zweite Kunststoff Polyetheretherketon (PEEK) umfasst, wobei das Einlegeteil (20) eine Auflagefläche (50) aufweist zur Auflage von Verbindungsmitteln.

2. Gehäuse (10) nach Anspruch 1, wobei
das Einlegeteil (20) als Buchse ausgebildet ist.

3. Gehäuse (10) nach Anspruch 1 oder 2, wobei
der Füllstoff einen Anteil
von 40 bis 80 Volumenprozent,
und/oder von 50 bis 70 Volumenprozent,
und/oder von 60 Volumenprozent,
des Einlegeteils (20) aufweist.

4. Gehäuse (10) nach einem der vorhergehenden Ansprüche, wobei der Füllstoff ein synthetisches und/oder mineralisches Material umfasst.

5. Gehäuse (10) nach einem der vorhergehenden Ansprüche, wobei der Füllstoff Kohlenstofffasern, Glasfasern und/oder Glaskugeln umfasst.

6. Gehäuse (10) nach einem der vorhergehenden Ansprüche, wobei der Füllstoff eine Glas-Basalt und/oder eine Kohlenstofffaser umfasst.

7. Gehäuse (10) nach einem der vorhergehenden Ansprüche, wobei das Einlegeteil (20) rotationssymmetrisch um die Längsachse (40) der Durchgangsöffnung (30) ausgebildet ist.

8. Gehäuse (10) nach einem der vorhergehenden Ansprüche, wobei die Durchgangsöffnung (30) des Einlegeteils (20) ein Gewinde aufweist.

9. Gehäuse (10) nach einem der vorhergehenden Ansprüche, wobei die Auflagefläche (50) sich in einem Winkel von 90° zur Längsachse (40) der Durchgangsöffnung (30) erstreckt.

10. Gehäuse (10) nach einem der vorhergehenden Ansprüche, wobei das Einlegeteil (20) eine Farbe aufweist, die einer Materialeigenschaft und/oder einer geometrischen Eigenschaft des Einlegeteils zuordenbar ist.

11. Gehäuse (10) nach einem der vorhergehenden Ansprüche, wobei das Einlegeteil (20) einen hohlzylinderförmigen Bereich (100) aufweist, der an seiner Außenumfangsfläche (110) aufgeraut und/oder zahnradförmig profiliert (120) ist.

12. Gehäuse (10) nach einem der vorhergehenden Ansprüche, wobei das Einlegeteil (20) zur Bildung des Gehäuses (10) mit dem ersten Kunststoff umspritzt ist.

13. Gehäuse (10) nach einem der Ansprüche 1 bis 11, wobei das Einlegeteil (20) in eine dafür vorgesehen Öffnung (130) des Gehäuses eingepresst ist.

14. Gehäuse (10) nach einem der Ansprüche 1 bis 11, wobei das Einlegeteil (20) in eine dafür vorgesehen Öffnung (130) des Gehäuses (10) eingespritzt ist.

## Claims

1. Housing (10) made of a first plastic, with a non-positively and/or positively connected insert (20) having a through-opening (30) for receiving a fastening means, the insert having a material which comprises at least one second plastic with at least a proportion of 30 to 90 percent by volume of granular and/or fibrous filler, the second plastic comprising polyetheretherketone (PEEK), the insert (20) having a supporting surface (50) for supporting connecting means.

2. Housing (10) according to Claim 1,
the insert (20) being formed as a bushing.

3. Housing (10) according to Claim 1 or 2,
the filler comprising a proportion
of 40 to 80 percent by volume,
and/or of 50 to 70 percent by volume,
and/or of 60 percent by volume,
of the insert (20).

4. Housing (10) according to one of the preceding claims,
the filler comprising a synthetic and/or mineral material.

5. Housing (10) according to one of the preceding claims,
the filler comprising carbon fibres, glass fibres and/or glass beads.

6. Housing (10) according to one of the preceding claims,
the filler comprising glass-basalt and/or a carbon fibre.

7. Housing (10) according to one of the preceding claims,
the insert (20) being formed rotationally symmetrically about the longitudinal axis (40) of the through-opening (30).

8. Housing (10) according to one of the preceding claims, the through-opening (30) of the insert (20) having a thread.

9. Housing (10) according to one of the preceding claims,
the supporting surface (50) extending at an angle of 90° in relation to the longitudinal axis (40) of the through-opening (30).

10. Housing (10) according to one of the preceding claims,
the insert (20) having a colour that can be assigned to a material property and/or a geometrical property of the insert.

11. Housing (10) according to one of the preceding claims,
the insert (20) having a hollow-cylindrical region (100), which is roughened and/or is profiled (120) in the form of gear wheels on its outer circumferential surface (110).

12. Housing (10) according to one of the preceding claims,
the insert (20) being encapsulated with the first plastic to form the housing (10).

13. Housing (10) according to one of claims 1 to 11,
the insert (20) being press-fitted in an opening (130) provided for it in the housing.

14. Housing (10) according to one of Claims 1 to 11, the insert (20) being injection-moulded in an opening (130) provided for it in the housing (10).

## Revendications

1. Boîtier (10) en une première matière plastique comprenant une pièce d'insertion (20) reliée par accouplement de force et/ou accouplement de forme, comprenant une ouverture de passage (30) pour la réception d'un moyen de fixation, la pièce d'insertion comprenant un matériau qui comprend au moins une deuxième matière plastique contenant au moins une proportion de 30 à 90 pour cent en volume de charge granulaire et/ou fibreuse, la deuxième matière plastique comprenant de la polyéther-éther-cétone (PEEK), la pièce d'insertion (20) comprenant une surface de pose (50) pour la pose de moyens de liaison.

2. Boîtier (10) selon la revendication 1, dans lequel la pièce d'insertion (20) est configurée sous la forme d'une douille.

3. Boîtier (10) selon la revendication 1 ou 2, dans lequel la charge comprend une proportion de 40 à 80 pour cent en volume, et/ou de 50 à 70 pour cent en volume, et/ou de 60 pour cent en volume, de la pièce d'insertion (20) .

4. Boîtier (10) selon l'une quelconque des revendications précédentes, dans lequel la charge comprend un matériau synthétique et/ou minéral.

5. Boîtier (10) selon l'une quelconque des revendications précédentes, dans lequel la charge comprend des fibres de carbone, des fibres de verre et/ou des billes de verre.

6. Boîtier (10) selon l'une quelconque des revendications précédentes, dans lequel la charge comprend un verre-basalte et/ou une fibre de carbone.

7. Boîtier (10) selon l'une quelconque des revendications précédentes, dans lequel la pièce d'insertion (20) est configurée sous forme symétrique par rotation autour de l'axe longitudinal (40) de l'ouverture de passage (30).

8. Boîtier (10) selon l'une quelconque des revendications précédentes, dans lequel l'ouverture de passage (30) de la pièce d'insertion (20) comprend un filetage.

9. Boîtier (10) selon l'une quelconque des revendications précédentes, dans lequel la surface de pose (50) s'étend à un angle de 90° par rapport à l'axe longitudinal (40) de l'ouverture de passage (30).

10. Boîtier (10) selon l'une quelconque des revendications précédentes, dans lequel la pièce d'insertion (20) présente une couleur, qui peut être attribuée à une propriété de matériau et/ou une propriété géométrique de la pièce d'insertion.

11. Boîtier (10) selon l'une quelconque des revendications précédentes, dans lequel la pièce d'insertion (20) comprend une zone en forme de cylindre creux (100), qui est rugosifiée et/ou profilée en forme de roue dentée (120) sur sa surface périphérique extérieure (110).

12. Boîtier (10) selon l'une quelconque des revendications précédentes, dans lequel la pièce d'insertion (20) est surmoulée avec la première matière plastique pour la formation du boîtier (10).

13. Boîtier (10) selon l'une quelconque des revendications 1 à 11, dans lequel la pièce d'insertion (20) est pressée dans une ouverture (130) du boîtier prévue pour cela.

14. Boîtier (10) selon l'une quelconque des revendications 1 à 11, dans lequel la pièce d'insertion (20) est injectée dans une ouverture (130) du boîtier (10) prévue pour cela.
